Europäisches Patentamt

European Patent Office

Office européen des brevets

(19)

(11) Numéro de publication : **0 466 556 A1**

(12) **DEMANDE DE BREVET EUROPEEN**

(21) Numéro de dépôt : **91401816.3**

(22) Date de dépôt : **02.07.91**

(51) Int. Cl.⁵ : **H03H 1/00, H01G 9/00**

(30) Priorité : **13.07.90 FR 9008953**

(43) Date de publication de la demande :
**15.01.92 Bulletin 92/03**

(84) Etats contractants désignés :
**BE DE ES FR GB IT NL**

(71) Demandeur : **COMPAGNIE EUROPEENNE DE COMPOSANTS ELECTRONIQUES LCC**
**50, rue Jean-Pierre Timbaud**
**F-92400 Courbevoie (FR)**

(72) Inventeur : **Delalande, François,**
**Thomson-CSF, SCPI**
**Cedex 67**
**F-92045 Paris La Défense (FR)**
Inventeur : **Poupard, Dominique,**
**Thomson-CSF, SCPI**
**Cedex 67**
**F-92045 Paris La Défense (FR)**

(74) Mandataire : **Ruellan-Lemonnier, Brigitte et al**
**THOMSON-CSF SCPI**
**F-92045 PARIS LA DEFENSE CEDEX 67 (FR)**

(54) **Procédé de réalisation d'un composant LC de type intégré.**

(57)     La présente invention concerne un procédé de réalisation d'un composant LC de type intégré.
Le procédé comporte les étapes suivantes :
— bobinage d'un élément longiligne en métal à effet de valve dont les extrémités constituent deux électrodes (1A, 1B),
— anodisation de l'élément pour former une couche diélectrique,
— imprégnation par un électrolyte (5), et
— mise en place de manière connue d'une troisième électrode (4).
Application aux composants passifs intégrés.

FIG.3

EP 0 466 556 A1

La présente invention concerne un procédé de réalisation d'un composant LC de type intégré. Un composant LC est constitué par l'association d'un élément selfique et d'un élément capacitif, ces deux éléments étant destinés à fonctionner à certaines fréquences selon une loi LC $\omega^2 = 1$. De tels composants LC ont en général une fonction de filtrage et sont utilisés, par exemple, dans les tuners.

Actuellement les composants LC sont constitués par les deux éléments L et C réalisés séparément et regroupés dans un même boîtier ou un même moulage. Ces composants ont pour principal inconvénient d'être relativement gros et onéreux.

D'autre part, il existe sur le marché des condensateurs électrolytiques utilisant une anode réalisée en un métal à effet de valve et un électrolyte solide ou liquide. En général, de tels condensateurs sont réalisés à partir d'un élément en feuille gravé qui est plié ou enroulé pour former le bloc d'anode qui est soumis à une anodisation de la feuille pour former une mince couche diélectrique suivie d'une imprégnation ou enrobage par l'électrolyte solide ou liquide puis d'une mise en place du contact de cathode.

La présente invention a aussi pour but de proposer un procédé de fabrication de composants LC qui permettent de remédier aux inconvénients des composants de l'art antérieur en réalisant un composant de type intégré.

La présente invention a aussi pour but de proposer un procédé de fabrication d'un composant LC de type intégré utilisant une technique semblable à celle utilisée pour la fabrication des condensateurs électrolytiques.

En conséquence, la présente invention a pour objet un procédé de réalisation d'un composant LC de type intégré, caractérisé en ce qu'il comporte les étapes suivantes :

– bobinage d'un élément longiligne en métal à effet de valve dont les extrémités constituent deux électrode,

– anodisation de l'élément pour former une couche électrique,

– imprégnation par un électrolyte, et.

– mise en place de manière connue d'une troisième électrode.

Selon un mode de réalisation particulier, le bobinage peut être réalisé sur un noyau amovible ou non. Dans le cas où le noyau est amovible, on obtient un bobinage du type en l'air. Lorsque le bobinage est réalisé sur un noyau non amovible, ce noyau peut être en un matériau isolant de manière à former un simple support ou en un matériau magnétique, par exemple en ferrite.

Selon une autre variante de réalisation, le bobinage peut être réalisé sur un mandrin comportant un noyau magnétique mobile permettant de réaliser un réglage de la valeur de la self.

D'autre part, l'élément longiligne est constitué par un fil ou par une feuille allongée qui peut être éventuellement gravé. Ce fil ou cette feuille est réalisé en un métal à effet de valve, à savoir en un métal choisi parmi l'aluminium, le tantale, le niobium ou d'autres métaux similaires.

Selon une autre caractéristique de la présente invention, la valeur de l'élément selfique est déterminée par la longueur de l'élément longiligne et la valeur de l'élément capacitif est déterminée par le taux de gravure de l'élément longiligne et/ou la tension d'oxydation.

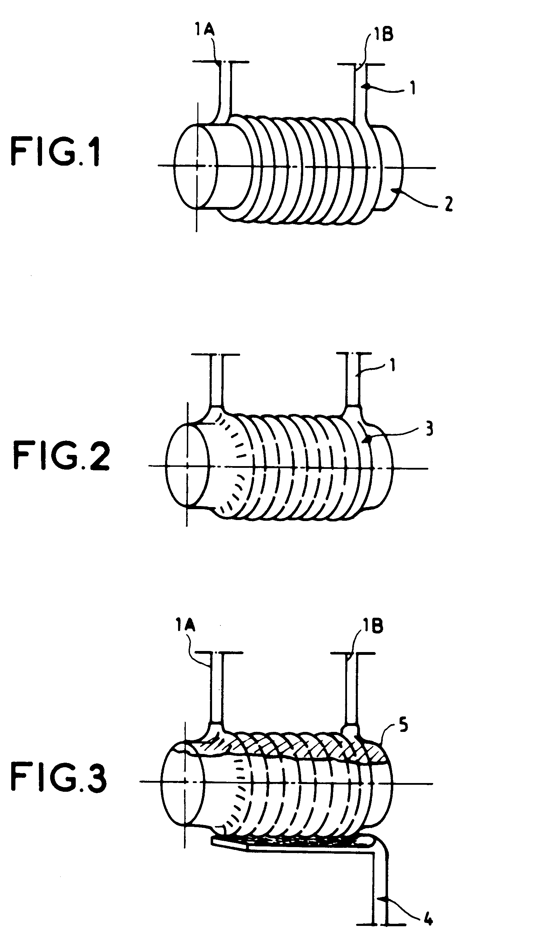

D'autres caractéristiques et avantages de l'invention apparaîtront à la lecture de la description d'un mode de réalisation préférentiel faite ci-après avec référence au dessin ci-annexé dans lequel les figures 1 à 3 représentent différentes étapes du procédé de réalisation d'un composant LC de type intégré conforme à la présente invention.

Comme représenté sur la figure 1, dans une première étape, on bobine un fil 1 sur un mandrin 2. Ce fil qui peut être gravé ou non, est enroulé sur lui-même sous forme d'un solénoïde à une couche avec des spires jointives. Toutefois, le fil peut aussi être enroulé sous forme d'un solénoïde à plusieurs couches avec des spires jointives ou non. Ce fil enroulé constitue la partie self. En conséquence, il présente une longueur déterminée en fonction de la valeur souhaitée pour la self. D'autre part, le mandrin 2 peut être constitué par un mandrin amovible pour obtenir un bobinage dit en l'air ou par un mandrin non amovible réalisé en un matériau isolant formant simple support ou en un matériau magnétique tel qu'en ferrite. Selon une variante de réalisation non représentée, le fil 1 peut être bobiné sur un mandrin creux possédant un noyau plongeur de réglage en matériau magnétique, ceci permet de modifier la valeur de la partie self. La section du mandrin est circulaire, dans le mode de réalisation représenté, toutefois il est évident pour l'homme de l'art que le mandrin peut présenter une section quelconque circulaire, carrée, rectangulaire etc. D'autre part, le mandrin peut être rectiligne, en forme de bobine à jouer ou en forme de tore. Le fil 1 utilisé dans la présente invention est réalisé en un métal à effet de valve, à savoir en un métal anodisable tel que l'aluminium, le tantale, le niobium ou similaire. Les deux extrémités 1A et 1B du fil forment les deux électrodes de la partie self.

La partie condensateur est réalisée en utilisant les techniques connues dans le domain des condensateurs électrolytiques, plus particulièrement des condensateurs à l'électrolyte solide. En conséquence, on réalise tout d'abord l'anodisation à savoir l'oxydation anodique du fil de manière à créer à la fois, l'isolation spire à spire de la self et une couche diélectrique pour le condensateur. L'anodisation ou oxydation du fil 1 est réalisée de manière classique au moyen d'un bain de reformation telle qu'une solution d'acétate d'amonium, le fil étant soumis à une tension d'oxydation permettant de contrôler la valeur de la partie capacitive. Ensuite on réalise, selon les moyens connus de l'homme de l'art, l'imprégnation ou l'enrobage du fil anodisé ainsi obtenu par un électrolyte solide ou liquide. Dans le cas d'un électrolyte solide, plusieurs électrolytes organiques ou inorganiques peuvent être utilisés, par exemple du dioxyde de manganèse dont l'imprégnation est réalisée de façon connue en soi par pyrolyse ou des électrolytes telles que les sels de tétracyanoquinodiméthane, ce produit étant mis en solution dans un solvant tel que le lactone ou l'acétonitrile et l'ensemble mandrin et fil étant trempés dans la solution. On obtient donc le dépôt d'une couche conductrice 3 formant la troisième électrode sur l'ensemble du fil oxydé 1 et du mandrin 2, comme représenté sur la figure 2. Ensuite pour améliorer la conductivité électrique entre la troisième électrode ou cathode constituée par l'électrolyte 3 et le contact de cathode 4, on passe le fil oxydé 1 revêtu de l'électrolyte 3 clans un bain de graphite et on les recouvre ensuite d'une métallisation, par exemple d'une argenture, comme représenté par la référence 5 sur la figure 3. Sur cette argenture on fixe le contact de cathode 4. Ces étapes étant bien connues dans la technologie des condensateurs électrolytiques, elles ne seront donc pas décrites de manière plus détaillée. L'ensemble peut alors être monté dans un boîtier ou être moulé quelle que soit la finition. Dans ce cas, l'élément capacitif est obtenu entre l'électrode 4 et l'une des électrodes 1A ou 1B, la valeur de l'élément capacitif étant fonction du taux de gravure du fil et/ou de la tension d'oxydation. D'autre part, il est possible de réaliser avec cet élément LC différents types de filtres à savoir des filtres en $\pi$ ou des filtres en C, selon le mode de connexion des différentes électrodes.

A titre d'exemple, en utilisant le format normalisé C (6,3 mm x 3,5 mm x 2,8 mm), on a pu obtenir un composant LC de type intégré présentant les valeurs de capacité et de self suivantes :

– capacité de 0,1 $\mu$F à 47 $\mu$F

– self de 40 nH à 16 $\mu$H

ce qui, pour ce format, permet d'avoir toutes les combinaisons possibles sur une gamme de fréquence importante allant de 5,8 KHz à 2,5 MHz.

La présente invention a été décrite en se référant à un fil, toutefois une feuille longiligne peut aussi être utilisée.

## Revendications

1. Procédé de réalisation d'un composant LC de type intégré, caractérisé en ce qu'il comporte les étapes suivantes :
   – bobinage d'un élément longiligne (1) en métal à effet de valve dont les extrémités constituent deux électrodes (1A, 1B),
   – anodisation de l'élément pour former une couche diélectrique (3),
   – imprégnation par un électrolyte (5), et
   – mise en place de manière connue d'une troisième électrode (4).

2. Procédé selon la revendication 1, caractérisé en ce que le bobinage est réalisé sur un noyau (2) amovible ou non.

3. Procédé selon la revendication 2, caractérisé en ce que, dans le cas d'un noyau non-amovible, celui-ci est réalisé en un matériau magnétique ou en un matériau isolant.

4. Procédé selon la revendication 1, caractérisé en ce que le bobinage est réalisé sur un mandrin comportant un noyau magnétique mobile.

5. Procédé selon l'une quelconque des revendications 1 à 4, caractérisé en ce que l'élément longiligne (1) est constitué par un fil ou par une feuille.

6. Procédé selon la revendication 5, caractérisé en ce que le fil ou la feuille est gravé.

7. Procédé selon l'une quelconque des revendications 1 à 6, caractérisé en ce que l'élément en métal à effet de valve est réalisé en un métal choisi parmi l'aluminium, le tantale, le niobium ou similaire.

8. Procédé selon l'une quelconque des revendications 1 à 6, caractérisé en ce que la longueur de l'élément longiligne est fonction de la valeur de la self et en ce que, la valeur de la capacité est donnée par le taux de gravure de l'élément bobiné et/ou la tension d'oxydation.

FIG.1

FIG.2

FIG.3

EP 0 466 556 A1

Office européen
des brevets

**RAPPORT DE RECHERCHE EUROPEENNE**

Numero de la demande

EP    91 40 1816

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | DE-A-1 541 651 (TELEFUNKEN)<br>* page 2, ligne 17 - ligne 31 *<br>* page 2, ligne 36 - page 3, ligne 7; figures 1-3 *<br>--- | 1-3,5 | H03H1/00<br>H01G9/00 |
| A | EP-A-044 068 (SIEMENS)<br>* page 1, ligne 7 - ligne 27 *<br>* page 4, ligne 32 - page 5, ligne 12; figure 1 *<br>----- | 1,5,7 | |

**DOMAINES TECHNIQUES RECHERCHES (Int. Cl.5)**

H03H
H01G

Le présent rapport a été établi pour toutes les revendications

| Lieu de la recherche | Date d'achèvement de la recherche | Examinateur |
|---|---|---|
| LA HAYE | 26 SEPTEMBRE 1991 | WRIGHT J.P. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
............................................................
& : membre de la même famille, document correspondant

EPO FORM 1503 03.82 (P0402)

5